# EUROPEAN PATENT SPECIFICATION

(11) **EP 1 436 218 B1**
(45) Date of publication and mention of the grant of the patent: **02.08.2006**
(21) Application number: 01979213.4
(22) Date of filing: 19.10.2001
(51) Int. Cl.: B65D 85/90, B65D 81/26, H01L 21/00, H05K 13/00, G01N 13/22

(54) **A BAG**
BEUTEL
SAC

(43) Date of publication of application: 14.07.2004
(73) Proprietor: Infineon Technologies AG, 81669 München (DE)
(72) Inventor: SURATTEE, Najib, Khan, Singapore 520109 (SG); THANG, Tak, Seng, Singapore 310166 (SG); LOH, CHee, Ping, Benedict, Singapore 380128 (SG); NG, Bee, Poh, Christine, Singapore 470772 (SG); ONG, Wai, Lian, Jenny, Singapore 751468 (SG); YEONG, Kok, Cheong, Bernard, Singapore 556354 (SG); TYE, Ching, Yun, Singapore 820295 (SG)
(74) Representative: Howe, Steven
(86) International application number: PCT/SG2001/000223
(87) International publication number: WO 2003/042072

(56) References cited:
- US-A- 4 971 196
- US-A- 5 224 373
- US-A- 5 293 996
- US-A- 5 875 892

## Description

The invention relates to a bag, and especially a bag for an electronics device which is substantially impervious to moisture.

Semiconductor devices are conventionally stored and transported in bags that are impervious to moisture. Typically, the bag material includes a metal foil layer which is normally opaque. In addition to the semiconductor device, the bags usually also contain a desiccant to ensure that the air within the bag remains as dry as possible, and a moisture indicator to enable a user to confirm that the moisture within the bag is below a pre-defined level when the bag is opened.

However, one of the problems with this conventional system is that it is necessary to have two additional components (the desiccant and the moisture indicator), which need to be inserted into the bag with the semiconductor device prior to sealing of the bag. In addition, it is not possible to view the moisture indicator without first opening the bag.

US 4,971,196, on which the preamble of claim 1 is based, describes a magazine for semiconductor packages. The magazine is stored in an interior box. Silica gel for absorbing moisture is put between the wall of the box and the side surface of the magazine. The interior box is then inserted into a bag and, once the bag has been deaerated, the bag is sealed closed. On the inner surface of one wall of the bag is a humidity indicator arranged so that it can be viewed from the outside through the transparent bag.

In accordance with the present invention, there is provided a bag comprising side walls which are substantially impervious to moisture and having an opening at one end which is adapted to be sealed, a portion of a side wall comprising a substantially transparent material which is substantially impervious to moisture and a moisture indicating material mounted within the bag adjacent to the transparent material to enable the moisture indicating material to be viewed through the transparent material, and at least a portion of the moisture indicator material being exposed to air within the bag, characterized in that a side wall of the bag further comprises a desiccant material which defines at least a portion of an inner surface of the side wall.

The side walls of the bag may comprise a layer of the desiccant material on the inside. The desiccant material may be located within a porous bag.

Typically, the desiccant material may be a silica gel.

Preferably, the side walls of the bag comprise a laminated material. In one arrangement, the side walls of the bag comprise the laminated material on the outside and a layer of the desiccant material on the inside. The laminated material may comprise a metal foil.

Preferably, the substantially transparent material may be a transparent moisture barrier film, such as DY3008-NM-792-260 moisture barrier film manufactured by Dou Yee Enterprises (S) Pte Ltd.

Typically, the bag is for containing an electronics device, such as a packaged semiconductor device.

An example of a bag in accordance with the invention will now be described with reference to the accompanying drawings, in which:
Figure 1 shows a bag for a semiconductor device; and
Figure 2 is a cross-sectional view along the line AA in Figure 1.

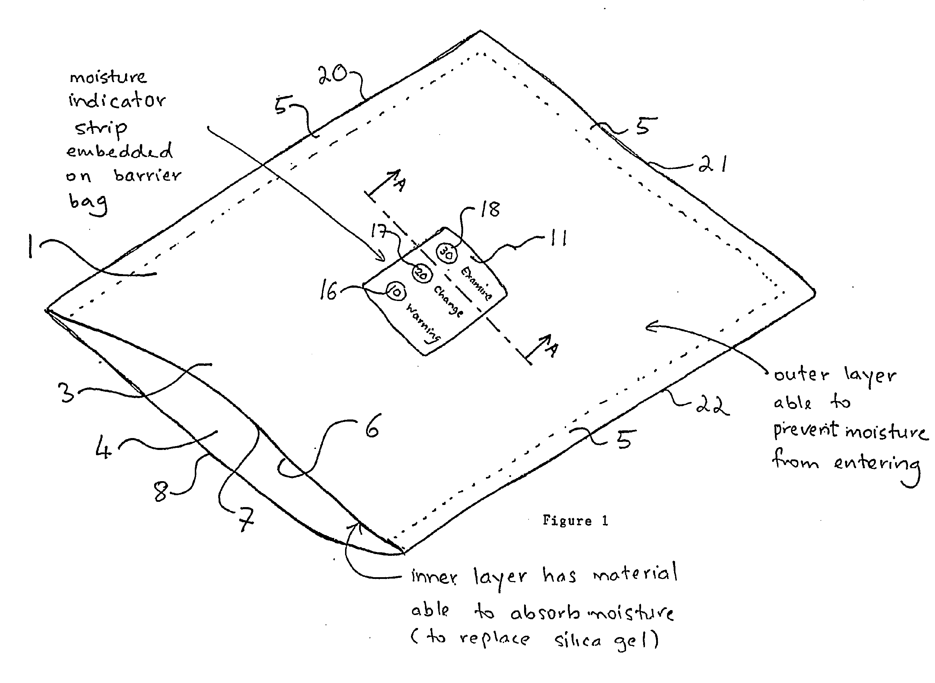

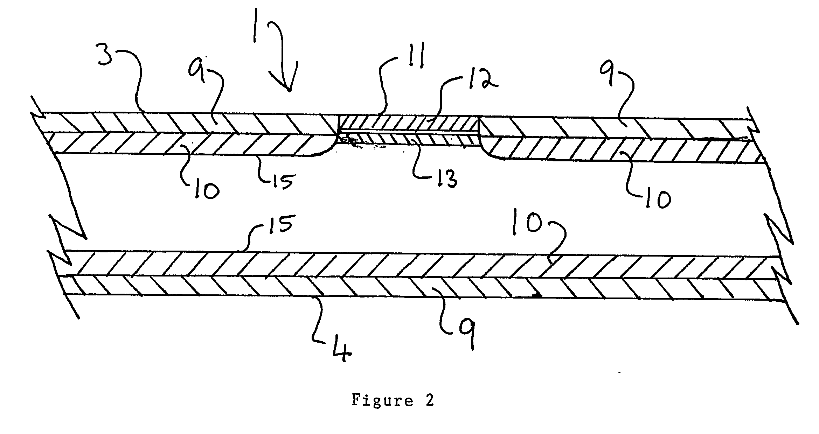

Figures 1 and 2 show a bag 1. The bag 1 is fabricated from two rectangular sheets 3, 4 of flexible material that are joined together by a weld 5 along three edges 20, 21, 22 so that the each sheet 3, 4 defines a side wall of the bag 1. The sheets 3, 4 each have a respective fourth edge 7, 8 that defines an opening 6 into which a packaged semiconductor device (not shown) may be inserted prior to sealing the opening 6 by sealing together the edges 7, 8, for example by a thermoplastic welding process.

The sheets 3, 4 each include a laminated aluminium foil material 9 on the outside and a layer of a desiccant material 10, such as silica gel, on the inside. Typically, the desiccant material 10 may be located within a porous inner bag 15 that is attached to the inner wall of the foil material 9. The sheet 3 includes a window portion 11 which is formed from a substantially transparent material 12 which is also substantially impervious to moisture. For example, a suitable material may be DY3008-NM-792-260 moisture barrier film produced by Dou Yee Enterprises (S) Pte Ltd. Located adjacent to the transparent material 12 is a moisture indicating material 13, which is located on the inside of the transparent material 12.

In use, a packaged semiconductor device is placed within the bag 1 and the ends 7, 8 of the sheets 3, 4 are sealed together to seal the semiconductor device within the bag 1. The desiccant 10 on the inside of the side walls 3, 4 absorbs any moisture within the bag 1 after it has been sealed. In addition, after the bag has been sealed, a user can view the moisture indicator 13 through the transparent material 12 to ensure that the moisture within the bag 1 is below a predetermined level. As shown in Figure 1, the moisture indicator 13 may comprise three separate moisture level indicators 16, 17, 18. For example, the indicator 16 may be a first warning that the moisture in the bag 1 is approaching a danger level, the indicator 17 may provide an intermediate warning that indicates to a user to put the semiconductor device into a new bag, and the indicator 18 may be provide a warning that the moisture levels have exceeded the recommended maximum level and that the electronic device within the bag should be inspected before use.

## Claims

1. A bag (1) comprising side walls which are substantially impervious to moisture and having an opening (6) at one end which is adapted to be sealed, a portion (11) of a side wall comprising a substantially transparent material (12) which is substantially impervious to moisture and a moisture indicating material (13) mounted within the bag (1) adjacent to the transparent material (12) to enable the moisture indicating material (13) to be viewed through the transparent material (12), and at least a portion of the moisture indicating material (13) being exposed to air within the bag (1),
**characterized in that**
a side wall of the bag (1) further comprises a desiccant material (10) which defines at least a portion of an inner surface of the side wall.

2. A bag (1) according to claim 1, wherein the side walls of the bag (1) comprise a layer of the desiccant material (10) on the inside.

3. A bag (1) according to claim 2, wherein the desiccant material (10) is located within a porous bag (15).

4. A bag (1) according to any of the preceding claims, wherein the desiccant material (10) comprises a silica gel.

5. A bag (1) according to any of the preceding claims, wherein the side walls of the bag comprise a laminated material.

6. A bag (1) according to claim 5, wherein the side walls of the bag comprise the laminated material on the outside and a layer of the desiccant material (10) on the inside.

7. A bag (1) according to claim 5 or claim 6, wherein the laminated material comprises a metal foil (9).

8. A bag (1) according to any of the preceding claims, wherein the substantially transparent material (12) comprises a transparent moisture barrier film.

9. A bag (1) for an electronics device, the bag being in accordance with any of the preceding claims.

10. A bag (1) for a packaged semiconductor device, the bag being in accordance with any of the preceding claims.

## Patentansprüche

1. Beutel (1), der Seitenwände umfasst, die im Wesentlichen feuchtigkeitsundurchlässig sind, und an einem Ende eine zum dichten Verschließen ausgeführte Öffnung (6) hat, wobei ein Abschnitt (11) einer Seitenwand ein im Wesentlichen transparentes Material (12), das im Wesentlichen feuchtigkeitsundurchlässig ist, und ein feuchtigkeitsanzeigendes Material (13) umfasst, das neben dem transparenten Material (12) in dem Beutel (1) angebracht ist, damit das feuchtigkeitsanzeigende Material (13) durch das transparente Material (12) betrachtet werden kann, und wobei wenigstens ein Teil des feuchtigkeitsanzeigenden Materials (13) der Luft in dem Beutel (1) ausgesetzt ist,
**dadurch gekennzeichnet, dass** eine Seitenwand des Beutels (1) ferner ein Trockenmittelmaterial (10) umfasst, das wenigstens einen Abschnitt einer inneren Oberfläche der Seitenwand definiert.

2. Beutel (1) nach Anspruch 1, bei dem die Seitenwände des Beutels (1) an der Innenseite eine Schicht des Trockenmittelmaterials (10) umfassen.

3. Beutel (1) nach Anspruch 2, bei dem sich das Trockenmittelmaterial (10) in einem porösen Beutel (15) befindet.

4. Beutel (1) nach einem der vorhergehenden Ansprüche, bei dem das Trockenmittelmaterial (10) ein Silikagel umfasst.

5. Beutel (1) nach einem der vorhergehenden Ansprüche, bei dem die Seitenwände des Beutels ein geschichtetes Material umfassen.

6. Beutel (1) nach Anspruch 5, bei dem die Seitenwände des Beutels das geschichtete Material an der Außenseite und eine Schicht des Trockenmittelmaterials (10) an der Innenseite umfassen.

7. Beutel (1) nach Anspruch 5 oder 6, bei dem das geschichtete Material eine Metallfolie (9) umfasst.

8. Beutel (1) nach einem der vorhergehenden Ansprüche, bei dem das im Wesentlichen transparente Material (12) einen transparenten Feuchtigkeitssperrschichtfilm umfasst.

9. Beutel (1) nach einem der vorhergehenden Ansprüche für ein Elektronikgerät.

10. Beutel (1) nach einem der vorhergehenden Ansprüche für einen in ein Gehäuse eingebauten Halbleiterbaustein.

## Revendications

1. Sac (1) comportant des parois latérales qui sont dans une large mesure étanches à l'humidité et ayant une ouverture (6) à une extrémité qui est adaptée pour être fermée hermétiquement, une portion (11) d'une paroi latérale comportant un matériau dans une large mesure transparent (12) qui est dans une large mesure étanche à l'humidité et un matériau indicateur d'humidité (13) monté à l'intérieur du sac (1) de manière adjacente au matériau transparent (12) pour permettre au matériau indicateur d'humidité (13) d'être vu au travers du matériau transparent (12), et au moins une portion du matériau indicateur d'humidité (13) étant exposée à l'air à l'intérieur du sac (1),
**caractérisé en ce que**
une paroi latérale du sac (1) comporte par ailleurs un matériau dessiccatif (10) qui définit au moins une portion d'une surface intérieure de la paroi latérale.

2. Sac (1) selon la revendication 1, dans lequel les parois latérales du sac (1) comportent une couche du matériau dessiccatif (10) à l'intérieur.

3. Sac (1) selon la revendication 2, dans lequel le matériau dessiccatif (10) est situé à l'intérieur d'un sac poreux (15).

4. Sac (1) selon l'une quelconque des revendications précédentes, dans lequel le matériau dessiccatif (10) comporte un gel de silice.

5. Sac (1) selon l'une quelconque des revendications précédentes, dans lequel les parois latérales du sac comportent un matériau laminé.

6. Sac (1) selon la revendication 5, dans lequel les parois latérales du sac comportent le matériau laminé à l'extérieur et une couche du matériau dessiccatif (10) à l'intérieur.

7. Sac (1) selon la revendication 5 ou la revendication 6, dans lequel le matériau laminé comporte une feuille de métal (9).

8. Sac (1) selon l'une quelconque des revendications précédentes, dans lequel le matériau dans une large mesure transparent (12) comporte un film transparent isolant contre l'humidité.

9. Sac (1) destiné à un dispositif électronique, le sac étant selon l'une quelconque des revendications précédentes.

10. Sac (1) destiné à un dispositif à semi-conducteurs encapsulé, le sac étant selon l'une quelconque des revendications précédentes.
